Europäisches Patentamt

European Patent Office

Office européen des brevets

(19)

(11) Publication number: 0 115 135

A1

(12) **EUROPEAN PATENT APPLICATION**

(21) Application number: 83307372.9

(22) Date of filing: 05.12.83

(51) Int. Cl.³: **G 01 R 31/28**
**H 01 R 23/72, H 05 K 13/08**

(30) Priority: 27.12.82 US 453098

(43) Date of publication of application:
08.08.84 Bulletin 84/32

(84) Designated Contracting States:
AT BE CH DE FR GB IT LI LU NL SE

(71) Applicant: GENRAD, INC.
300 Baker Avenue
Concord Massachusetts 01742(US)

(72) Inventor: Hulbig, Mark S.
35 High Street
Natick Massachusetts(US)

(74) Representative: Allsop, John Rowland et al,
c/o Edward Evans & Co. Chancery House 53-64 Chancery
Lane
London, WC2A 1SD(GB)

(54) **Electrical test fixture for printed circuit boards and the like.**

(57) A novel electrical test fixture for printed circuit boards and the like is disclosed involving a thin customized insulating planar panel (15) for actuating from its upper surface spring-loaded probes (6, 18) to connect with board test points (P), and enabling wire-wrap (12) or conductive strip connections (16) at the lower surface of the panel (15) to test equipment terminals also carried by the panel; with the intermediate base unit of the fixture carrying the probes and test equipment terminals being attached to the test equipment and the thin customizing panel being the changeable fixture element for different printed circuit boards.

ELECTRICAL TEST FIXTURE FOR

PRINTED CIRCUIT BOARDS AND THE LIKE


The present invention relates to improvements in electrical test fixtures for printed circuit boards and the like requiring the testing of thousands of test points in families of printed circuit boards with in-circuit testing instruments and systems configured with much fewer test terminals.

Prior systems for testing printed circuit boards have employed large, heavy, and expensive fixture housings full of wires and miscellaneous components for creating an interface between a physically known group of tester points or terminals and a set of randomly placed test points on a printed circuit board. The primary objective of the fixture housing was to create a low resistance, electrical connection between a printed circuit board and a testing system capable of

-2-

providing signals, power and grounds necessary to check the operability of the board under test. Testing interfaces to printed circuit boards have used housings 3-4 inches high, 30-60 pounds in weight and requiring manual assembly. An example of such a device is contained in United States Patent No. 2,918,648. The prior techniques involved manual assembly of a kit that would allow vacuum to be applied to the underside of a printed circuit board to be tested with atmospheric pressure pushing it evenly onto a layer of spring-loaded test probes as of the type described in United States Patent Nos. 4,105,970, 3,435,168 and 3,562,643, creating an electrical connection of the board to be tested back to the testing system to do the testing. Because of the physical dimensions of such previous devices, the ability automatically to make electrical connections (wiring) were very difficult. Also, the handling of these devices was very difficult, e.g., to test a 12 inch x 16 inch printed circuit board required a device 16 inches x 20 inches x 4.5 inches, weighing 35 pounds fully assembled. Once the testing of a group of boards has been completed, the housing must be removed from the tester and another housing installed. This process would be repeated with each different board type to be tested. Systems of this character are described, for example, in 1979 bulletins of Fairchild Camera and Instrument Corp. entitled "Thinline Product Access Unit (PAU)" and "Thinline Universal Wired Personalizer."

In accordance with the present invention, the need for such heavy apparatus and such repetitive test fixture apparatus is advantageously eliminated, enabling the use of a thin customizing panel to create the electrical interface to the printed circuit board to be tested and the testing instruments or system. The operation of this interface apparatus enables the major portion of the hardware to be placed on the test system without the requirement of removability for other board testing. For testing a different printed circuit board, only a minor section need be changed. The customized portion that is removable can have etched conductors, be semi-automatically, fully automatically or manually wired to provide the electrical connections to the printed circuit board under test.

An object of the present invention, therefore, is to provide a new and improved electrical test fixture apparatus that overcomes the disadvantages of prior fixture assemblies by enabling the changing of only a minor light-weight section thereof for different printed circuit boards to be tested. This is accomplished by using customizing panel capable of being automatically wired or having etched conductors as the principal customized part for each printed circuit board to be tested, providing a one-plane customized sheet of thin panel material that simplifies manual wiring or facilitates the use of automatic, semi-automatic wiring, or any useful combination in substantially a common plane below the panel.

In some testing applications, components must be mounted close to the printed circuit board to be tested. The components may be discrete electrical components, capacitors, resistors, etc. or integrated circuit packages. Another object of the invention is to provide a novel customized panel capable of having components mounted on it between the printed circuit board and the testing apparatus, with the distance between the printed circuit board and the components as short as possible.

A further object is to provide a novel fixture that reduces the manual labor needed to create a customized panel to test each type of board; also reducing the materials required to test each type of printed circuit board, thus reducing the costs to the consumer, and with a panel design compatible with printed circuit board manufacturing standards.

Still another object is to provide a novel test fixture wherein the design minimizes the storage space and weight of the customized panel used for testing a printed circuit board. For example, reducing prior art 30-60 pound constructions to the customized 5-15 pounds.

In summary, from one of its viewpoints, the invention embraces an electrical test fixture for printed circuit boards and the like having, in combination, a relatively thick insulating base sheet having aperture means transversely extending between its lower and upper surfaces and provided with means for mounting within the aperture means spring-activable electrical probes having unactivated positions, with the probes maintained below the said upper surface, and activated positions with the probes extending above said upper surface; a relatively thin self-supporting customizing panel the upper surface of which is adapted to be juxtaposed with the said lower surface of the base sheet and provided with holes extending between its lower and upper surface alined with the location of particular electrical probes within the base sheet aperture means corresponding to those probes that are to be activated above the upper surface of the base sheet to interface with and contact particular points of a particular printed circuit board or the like for which said panel is customized and that is to be positioned above said base sheet upper surface; said customizing panel having conducting inserts extending through said holes with means extending into said aperture means of the base sheet to contact and urge the electrical probes alined therewith to activated positions above the base sheet upper surface,

-8-

and electrical connection means extending below said customizing panel for connecting with electrical terminals of test equipment; and means for aligning and holding the assembly of printed circuit board, base sheet and customizing panel together to establish contact between said particular points of the printed circuit board and said test equipment terminals through the spring-urged contact of the said particular probes with said points. Preferred details and best mode embodiments will hereinafter be presented.

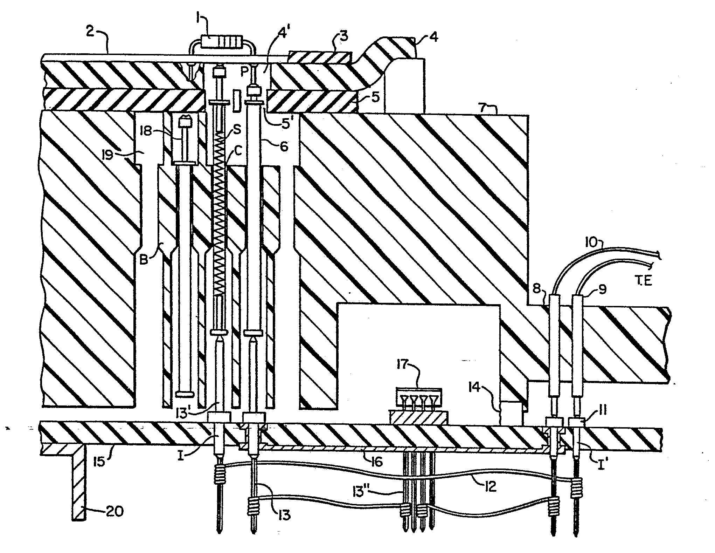

The invention will now be described in connection with the accompanying drawing the single figure of which is a longitudinal section of the test fixture assembly embodying the invention.

Referring to the drawing, the test fixture is shown comprising three major parts: (1) a basic sheet unit 7 that is designed to stay on the test instrument or other equipment TE, with only one such being required per test equipment;

(2) a thin customizing panel 15 which is changed for each different printed circuit board to be tested; and (3) an adaptor plate 5 which adapts the physical dimensions and alipnment points of the printed circuit board 2 being tested by the base unit 7.

The base sheet or block 7 is preferably of thick plastic that has a low coefficient of friction to metals, being provided with apertures transversely drilled between its lower and upper surfaces and containing mounting brackets B for receiving transversely extending spring-loaded electrical test probes 6, 18, as of the type described in the before-mentioned patents (having internal spring S acting against the electrical probe plunger) with unactivated probes stored as at 18 below the upper surface of the base sheet 7 and activated probes extending through the aperture 19 above the upper surface to make contact with predetermined test points or nodes P on the underside of a printed circuit board 2. The sheet 7 is criss-crossed with small channels C around the spring probe locations to enable vacuum holding underneath the board. The vacuum will draw the printed circuit board 2 under test onto the activated spring probes 6, holding the assembly together.

As before intimated, the spring-loaded test probes 6 do not contact the predetermined printed circuit board test points or nodes until they are activated (upward); such activation being effected by upward conductive extensions 13' of conductive inserts I extending through holes between the lower and upper surfaces of the before-mentioned thin customizing panel 15, as of a planar insulating sheet, in alignment with the preselected probes 6 that are to be activated to engage the predetermined test points or nodes P of the particular printed circuit board 2. Such activation is shown urging the right-most probe 6 to resiliently touch the node P as the assembly of printed circuit board 2, base sheet or block 7-8 and customizing panel 15 are vacuum or otherwise assembled together. Conventional cams and vacuum-holding apparatus are not illustrated in order to avoid detracting from the novelty of the construction underlying the invention. When assembled, the space between the customized panel 15 and the plastic base sheet 7 should be very small, as shown (juxtaposed), say 0.09 inch, more or less. In such activated position, resilient seals 14, as of rubber, may be slightly compressed as the inserts I-13' lift the aligned, selected test probes 6 needed for testing.

The spring probe interface connection is in turn connected to particular terminals 9 and conductors 10 of the test equipment TE by wire-wrap connections 12 from depending activator posts 13 from the inserts I, or by underside etched conductive paths 16--the terminals 9 being similarly contacted by a further set of conductive inserts I' at a laterally spaced portion 8 of the basic sheet 7, as at 11. The inserts I' may have depending post extensions 13 for wire-wrap connection, or may be connected to inserts I and thus the probes 6 and test points P of the printed circuit board 2 by conductive strips 16 on the lower surface of the customized panel 15. This interface pattern is common no matter what type of test equipment is used.

The thin insulating customizing panel 15 should be thick enough to be self-supporting, though it may be braced as at 20. The holes and inserts I are drilled to customize to the particular board to be tested. If etched conductive paths 16 are used, the holes will be metallized, also, as shown. Alternatively, as before explained, the wire-wrap connections 12 may be made between specific activator posts 13 and specific conducting elements 11 defined by the test.

Between the underside of the printed circuit board 2 and the upper surface of the base sheet or block 7 is preferably inserted an adaptor plate comprising an electrical insulating material called a clearance plate 5 and a rubber spacer 4. The plate 5 and spacer 4 are provided with respective openings 5' and 4' aligned or in register with the base sheet apertures, as shown, to permit the activated probes 6 to contact the selected nodes P of the printed circuit board 2. Around the perimeter of the printed circuit board to be tested should be a material, generally rubber, that seals the edges of the board so that vacuum leakage will be minimized. The rubber spacer 4 serves to space the board under test off the clearance plate 5 leaving an area for protrusions from the underside of the board. The edge of the rubber mat 4 may also create a seal around the adaptor plate.

With the base sheet or block 7 on the test machine, the adaptor plate 5 is loaded on top of it in proper alignment. The individualized customized panel 15 is moved up against the seal 14 while simultaneously lifting probes 6 with the activator pins 13'. The customizing panel 15 thus does the activating by lifting the spring-loaded test probes 6 and creating an electrical connection from the probe to a spring probe interface in the base sheet or block 7. The spring probe interface is connected to the testing machine via external interconnections 12 or 16. The customizing panel 15 is removable and is customized by changing the locations and electrical paths used for testing a printed circuit board. One customizing panel 15 is required for each different printed circuit board to be tested.

With the board 2 to be tested, the adaptor plate 5 and the customizing panel 15 installed on the base sheet or block 7, the printed circuit board is forced onto the test probes, while simultaneously the customizing panel is held rigid on the underside of the base sheet. For example, vacuum can be applied to the bottom of the printed

-15-

circuit board to be tested. While held together by pressure, the electrical path between the printed circuit board to be tested and the test machine is complete. After the pressure is released, the next board can be loaded in the assembly to be tested or the adaptor plate and customizing panel can be changed to test a different type of board.

It is sometimes required that additional components or circuits be introduced between the connections to test points of the board 2 and the test terminals 9 of the test equipment TE. The construction of the invention readily enables such by accommodating components such as 17 on the upper surface of the thin panel 15, as between the region of the probes 6 and the test terminals 9, with conductor posts extending below the lower surface of the panel as at 13"--shown used with wire-wrap connections.

Further modifications will also occur to those skilled in this art and such are considered to fall within the spirit and scope of the invention as defined in the appended claims.

CLAIMS

1.  An electrical test fixture for printed circuit boards and the like having, in combination, a relatively thick insulating base sheet having aperture means transversely extending between its lower and upper surfaces and provided with means for mounting within the aperture means spring-activable electrical probes having unactivated positions, with the probes maintained below the said upper surface, and activated positions with the probes extending above said upper surface; a relatively thin self-supporting customizing panel the upper surface of which is adapted to be juxtaposed with the said lower surface of the base sheet and provided with holes extending between its lower and upper surface aligned with the location of particular electrical probes within the base sheet aperture means corresponding to those probes that are to be activated above the upper surface of the base sheet to interface with and contact particular points of a particular printed circuit board or the like for which said panel is customized and that is to be positioned above said base sheet upper surface; said customizing panel having conducting inserts extending through said holes with means extending into said aperture means of the base sheet to contact and urge the electrical probes aligned therewith to activated positions above the base sheet upper surface, and electrical connection means extending below said customizing panel for connecting with electrical terminals of test equipment; and means for aligning and holding the assembly of printed circuit board, base sheet and customizing panel together to establish contact between said particular points of the printed circuit board and said test equipment terminals through the spring-urged contact of the said particular probes with said points.

2. An electrical test fixture as claimed in claim 1 and in which said electrical connection means comprises conductive posts extending from said conducting inserts below said customizing panel lower surface adapted for wrap-around wire connection to said terminals.

3. An electrical test fixture as claimed in claim 1 and in which said electrical connection means comprises conductive strips along said lower surface of said customizing panel.

4. An electrical test fixture as claimed in claim 1 and in which an insulating adaptor plate and resilient spacer sheet are inserted between said upper surface of the base sheet and the printed circuit board, being provided with apertures aligned with the activated electrical probes to receive the same and to enable them to contact the particular desired points of the printed circuit board.

5. An electrical test fixture as claimed in claim 1 and in which said customizing panel has a portion laterally spaced from said holes provided with further conducting inserts extending from the lower to the upper surface of said panel contacting said test equipment terminals.

6. An electrical test fixture as claimed in claim 5 and in which said further conducting inserts are provided with depending conductive posts connected to the first-named conducting posts by wrap-around wire connection.

7. An electrical test fixture as claimed in claim 5 and in which said further conducting inserts are connected to the first-named conducting inserts by conductive strips extending therebetween along the lower surface of said panel.

8.  An electrical test fixture as claimed in claim 5 and in which said further conducting inserts contact further electrical probes carried thereabove by said base sheet and connected to said test equipment terminals.

9.  An electrical test fixture as claimed in claim 5 and in which said panel is also provided with means for mounting electrical components thereon with connections provided at the lower surface of the panel for connecting to the conducting inserts.

10.  An electrical test fixture as claimed in claim 1 and in which said assembly is provided with means for enabling vacuum clamping thereof.

11.  An electrical test fixture as claimed in claim 1 and in which said thin customizing panel is planar to enable connections to be made below said panel in substantially a common plane.

### European Patent Office

## EUROPEAN SEARCH REPORT

### DOCUMENTS CONSIDERED TO BE RELEVANT

EP 83307372.9

| Category | Citation of document with indication, where appropriate, of relevant passages | Relevant to claim | CLASSIFICATION OF THE APPLICATION (Int. Cl. ³) |
|---|---|---|---|
| X,P | FR - A1 - 2 518 358 (EVERETT)  * Fig. 2,3 *  -- | 1,10,11 | G 01 R 31/28  H 01 R 23/72  H 05 K 13/08 |
| A | DE - A1 -3 038 665 (RIBA)  * Fig. 1-3 *  -- | 2,3,5, 7,8 | |
| A | DE - B2 - 2 427 118 (SIEMENS)  * Fig. 3 *  -- | 4 | |
| A | GB - A - 2 098 813 (JUNG)  * Fig. 1-4 *  -- | | |
| A | GB - A - 1 508 884 (INTERNATIONAL COMPUTERS LTD)  * Fig. 1,4 *  -- | | TECHNICAL FIELDS SEARCHED (Int. Cl. ³) |
| D,A | US - A - 2 918 648 (LUDMAN)  * Fig. 1-13 *  -- | | G 01 R 31/00  H 01 R 9/00  H 01 R 13/00 |
| D,A | US - A - 4 105 970 (KATZ)  * Fig. 1-3 *  -- | | H 01 R 23/00  H 01 R 33/00  H 05 K 13/00 |
| D,A | US - A - 3 435 168 (COONEY)  * Fig. 1-6 *  -- | | |
| D,A | US - A - 3 562 643 (SMITH)  * Fig. 1-8 *  ---- | | |

| | | | |
|---|---|---|---|
| The present search report has been drawn up for all claims | | | |
| Place of search VIENNA | Date of completion of the search 12-04-1984 | | Examiner KUNZE |